**Europäisches Patentamt**

**European Patent Office**

**Office européen des brevets**

(11) Numéro de publication : **0 374 007 B1**

## (12) FASCICULE DE BREVET EUROPEEN

(45) Date de publication du fascicule du brevet :
**25.03.92 Bulletin 92/13**

(51) Int. Cl.⁵ : **H05K 5/00**

(21) Numéro de dépôt : **89403380.2**

(22) Date de dépôt : **06.12.89**

(54) **Dispositif d'encapsulation hermétique pour composants électroniques.**

(30) Priorité : **16.12.88 FR 8816620**

(43) Date de publication de la demande :
**20.06.90 Bulletin 90/25**

(45) Mention de la délivrance du brevet :
**25.03.92 Bulletin 92/13**

(84) Etats contractants désignés :
**BE DE GB IT**

(56) Documents cités :
**DE-A- 3 335 530**
**FR-A- 1 577 883**
**FR-A- 2 303 443**

(73) Titulaire : **THOMSON-CSF**
**51, Esplanade du Général de Gaulle**
**F-92800 Puteaux (FR)**

(72) Inventeur : **Val, Christian**
**THOMSON-CSF SCPI Cédex 67**
**F-92045 Paris la Défense (FR)**

(74) Mandataire : **Benoit, Monique et al**
**THOMSON-CSF SCPI**
**F-92045 PARIS LA DEFENSE CEDEX 67 (FR)**

**Description**

La présente invention a pour objet un dispositif assurant une encapsulation hermétique de composants formant un circuit électronique.

Ainsi qu'il est connu, le problème de la suppression ou, à défaut, de la limitation de l'humidité dans les boîtiers de composants électroniques est un problème aigu. On sait que le contaminant ayant le rôle le plus important et le plus néfaste sur le plan de la fiabilité d'un composant discret ou d'un circuit intégré est la teneur en eau de l'ambiance environnante. En effet, notamment, l'humidité est susceptible de corroder les plots de connexion des circuits ; elle permet également aux ions de se solubiliser, ce qui renforce la corrosion. Cet effet est très sensible sur les circuits intégrés, et l'est d'autant plus que l'échelle d'intégration est plus élevée, c'est-à-dire que les plots de connexion sont plus petits.

Pour les applications à environnement sévère et hautes performances, telles que les applications militaires ou spatiales, il est connu d'utiliser des boîtiers de composants dont l'embase est en céramique et le capot en métal, scellé hermétiquement sur cette dernière, un dégazage avant mise sous boîtier étant en outre en général prévu. Un inconvénient de cette solution est son prix de revient, qui est très élevé.

On connaît par ailleurs des boîtiers d'encapsulation en matériau plastique, dont le coût est beaucoup plus bas mais qui présentent l'inconvénient de n'être pas hermétiques. En effet, dans un premier temps, les matériaux plastiques en eux-mêmes n'interdisent pas le passage des molécules d'eau de l'extérieur vers l'intérieur du boîtier. En outre, dans un second temps, l'accumulation d'eau susceptible de se produire sous les composants encapsulés induit des fissures dans le matériau plastique formant le boîtier, lors du montage sur la carte, du fonctionnement du composant et du chauffage qui en résulte. Cet inconvénient les rend inutilisables pour les applications hautes performances.

La présente invention a pour objet une encapsulation hermétique des composants utilisés dans les circuits électroniques, tels que pastilles semiconductrices, qui soit d'un prix de revient moins élevé que celui des boîtiers céramique-métal et qui assure la protection hermétique des composants, aussi bien lorsqu'ils sont montés de façon opérationnelle dans un équipement que lors des opérations de maintenance de ces derniers.

A cet effet, les composants sont encapsulés chacun dans un boîtier non hermétique, réalisé par exemple en matériau plastique, puis les boîtiers sont montés sur une carte de circuit imprimé, munie de moyens de connexion électriques et d'un capot scellé sur la carte de sorte à enfermer l'ensemble des boîtiers dans une deuxième enceinte telle qu'elle soit hermétique, les moyens de connexion étant laissés hors de la deuxième enceinte.

Plus précisément, l'invention a pour objet un dispositif tel que défini par la revendication 1.

De la sorte, les pastilles peuvent être montées aisément sur la carte par l'intermédiaire de leurs boîtiers, l'herméticité est assurée par la deuxième enceinte et l'ensemble est d'un coût relativement faible, les boîtiers plastiques étant peu onéreux et la deuxième enceinte encapsulant la totalité de la carte en une seule opération. En outre, les opérations de maintenance s'effectuant sur site par remplacement de cartes, la protection de celles-ci reste pleinement opérationnelle tant lors du remplacement que lors du stockage des pièces de rechange.

D'autres objets, particularités et résultats de l'invention ressortiront de la description suivante, donnée à titre d'exemple non limitatif et illustrée par les dessins annexés qui représentent :

– la figure 1a, une vue schématique d'un premier mode de réalisation du dispositif selon l'invention ;

– la figure 1b, une vue de dessus de ce même dispositif ;

– la figure 2, un autre mode de réalisation du dispositif selon l'invention.

Sur ces différentes figures, d'une part les mêmes références se rapportent aux mêmes éléments et, d'autre part, l'échelle réelle n'est pas respectée pour la clarté de l'exposé.

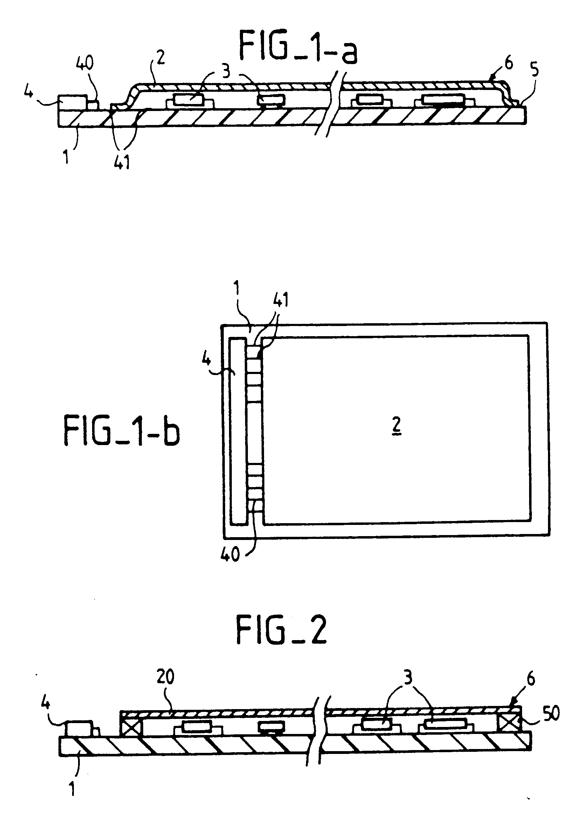

Sur les figures 1a et 1b, on a donc représenté schématiquement un premier mode de réalisation du dispositif selon l'invention, vu respectivement en coupe et de dessus.

On a représenté un circuit électronique constitué par un ensemble de composants, notamment des pastilles semi-conductrices, encapsulés dans des boîtiers 3 et disposés sur un substrat (ou carte) 1, portant un circuit imprimé, assurant classiquement la fixation mécanique des boîtiers et leur interconnexion électrique à l'aide de pistes conductrices 41, disposées sur la surface de la carte 1.

Classiquement également, la carte de circuit imprimé 1 comporte un connecteur 4, disposé à l'une de ses extrémités et sensiblement sur toute sa longueur. Ce connecteur comporte des contacts 40 venant reposer sur les pistes 41 de la carte 1 et assurant ainsi la connexion électrique.

Le dispositif comporte en outre un capot 2 recouvrant sensiblement la totalité de la surface de la carte 1, sauf les moyens de connexion 4, dont la périphérie est fixée de façon étanche sur la carte 1. Selon l'invention, on a ainsi formé autour des boîtiers 3 une deuxième enceinte, repérée 6, dont la fonction est d'assurer l'herméticité de l'ensemble du circuit électronique.

L'herméticité est assurée par le choix des matériaux formant la deuxième enceinte. A cet effet, la carte de circuit imprimé 1 doit être réalisée de sorte à ne pas permettre le passage des molécules d'eau ; elle peut être réalisée entièrement en un tel matériau (par exemple une céramique telle que l'alumine) ; elle peut encore être réalisée en un matériau non susceptible en lui-même de remplir la fonction, tel qu'une carte de circuit imprimé en verre époxy, mais recouverte, sur ses faces externes (inférieure et latérales) d'une couche interdisant le passage des molécules d'eau telle qu'une couche métallique (cuivre par exemple). De la même manière, le capot doit être réalisé en un -ou comporter une couche d'un- matériau ne permettant pas le passage des molécules d'eau, métal ou céramique par exemple. Dans le cas d'une carte en céramique et d'un capot métallique, le scellement hermétique 5 est constitué par exemple par une brasure. Il est à noter que l'alliage utilisé pour la brasure doit avoir une température de fusion supérieure à la température de stockage maximale de la carte, qui ne doit pas dépasser 150°C, mais, de préférence, inférieure à la température de refusion de l'alliage utilisé pour monter les composants sur la carte, en général de l'étain- plomb dont la température de fusion est voisine de 183°C. Dans le cas contraire, le chauffage nécessaire à la brasure doit être réalisé à l'aide de moyens permettant de le localiser. Il est à noter également que la brasure doit être réalisée non pas directement sur la carte 1 et les pistes d'interconnexion 41 mais sur une couche de matériau électriquement isolant, préalablement déposée sur l'ensemble 1-41 et non représentée sur les figures. Les boîtiers 3 n'ayant aucune fonction d'herméticité, ils peuvent être réalisés en tout matériau, plastique par exemple.

La figure 2 représente, schématiquement et vu en coupe, un deuxième mode de réalisation du dispositif selon l'invention.

Sur cette figure, on retrouve les boîtiers 3 d'encapsulation de composants électroniques montés sur la carte 1, qui porte le connecteur 4 à l'une de ses extrémités. La carte est recouverte d'un capot qui est, dans ce mode de réalisation, plan et repéré 20 ; il est monté sur la carte 1 par l'intermédiaire d'un cadre 50.

L'herméticité est ici encore assurée par le choix des matériaux formant la deuxième enceinte (6) ; c'est ainsi que la carte 1 est par exemple en céramique, le capot 20 par exemple métallique et le cadre 50 en un alliage de ferro-nickel.

L'intérêt du cadre 50 est que celui-ci peut être fixé, par brasure par exemple, sur la carte 1 avant le montage des boîtiers 3 ; cela lui permet par exemple d'être brasé à haute température, c'est-à-dire une température supérieure à la température de refusion de la brasure utilisée pour monter les boîtiers 3. Le capot 20 peut alors être scellé sur le cadre 50 par refusion, avec les conditions mentionnées pour le mode de réalisation décrit figure 1, ou par d'autres moyens évitant ces difficultés : soudure par laser, soudure électrique, etc...

## Revendications

1. Dispositif d'encapsulation hermétique pour composants électroniques, les composants étant encapsulés chacun dans un boîtier (3) non hermétique, les boîtiers étant montés sur un substrat (1) portant un circuit imprimé assurant l'interconnexion des boîtiers en un circuit électronique, le dispositif étant caractérisé par le fait que le substrat (1) comporte des moyens (4) de connexion électrique vers l'extérieur, reliés au circuit imprimé, et un capot (2, 20) scellé sur le substrat de façon à former une deuxième enceinte (6) encapsulant l'ensemble du substrat hors les moyens de connexion en une seule opération, l'herméticité de l'ensemble du circuit électronique étant assurée par le choix de chacun des matériaux formant le substrat, le capot et le scellement du capot sur le substrat et constituant la deuxième enceinte (6).

2. Dispositif selon la revendication 1, caractérisé par le fait que le substrat (1) est en céramique.

3. Dispositif selon la revendication 1, caractérisé par le fait que le substrat (1) est recouvert sur ses faces externes d'une couche d'un matériau assurant l'herméticité.

4. Dispositif selon l'une des revendications précédentes, caractérisé par le fait que le capot (2) est en métal ou en céramique.

5. Dispositif selon l'une des revendications précédentes, caractérisé par le fait que le scellement du capot sur le substrat est constituée par un brasage.

6. Dispositif selon l'une des revendications précédentes, caractérisé par le fait que le capot est scellé sur le substrat par l'intermédiaire d'un cadre (50).

7. Dispositif selon la revendication 5, caractérisé par le fait que le cadre (50) est constitué par un alliage de ferro-nickel.

## Patentansprüche

1. Vorrichtung zum hermetischen Einschließen elektronischer Bausteine, die je in ein nicht hermetisch geschlossenes Gehäuse (3) eingekapselt sind, wobei die Gehäuse auf einem Substrat (1) montiert sind, das eine gedruckte Schaltung trägt, die die Gehäuse miteinander zu einer elektronischen Schaltung verbindet, dadurch gekennzeichnet, daß das Substrat (1) Mittel (4) für den elektrischen Außenanschluß, die mit der gedruckten Schaltung verbunden sind, und eine Abdeckhaube (2, 20) aufweist, die auf dem Substrat unter Bildung einer zweiten Umhüllung (6) versiegelt ist, welche das gesamte Substrat mit Ausnahme der Anschlußmittel (4) in einem einzigen Verfahrensschritt einkapselt, wobei die hermetische Dichtheit der gesamten elektronischen Schaltung durch die Wahl jedes der Materialien des Substrats, der Abdeckhaube und der Versiegelung zwischen dem Substrat und der die zweite Umhüllung (6) bildenden Haube bewirkt wird.

2. Vorrichtung nach Anspruch 1, dadurch gekennzeichnet, daß das Substrat (1) aus Keramik besteht.

3. Vorrichtung nach Anspruch 1, dadurch gekennzeichnet, daß das Substrat (1) auf seinen Außenseiten mit einer Schicht aus einem die hermetische Dichtheit bewirkenden Material bedeckt ist.

4. Vorrichtung nach einem der vorhergehenden Ansprüche, dadurch gekennzeichnet, daß die Abdeckhaube (2) aus Metall oder Keramik besteht.

5. Vorrichtung nach einem der vorhergehenden Ansprüche, dadurch gekennzeichnet, daß die Versiegelung der Abdeckhaube auf dem Substrat aus einer Lötschicht besteht.

6. Vorrichtung nach einem der vorhergehenden Ansprüche, dadurch gekennzeichnet, daß die Abdeckhaube über einen Rahmen (50) auf dem Substrat versiegelt ist.

7. Vorrichtung nach Anspruch 5, dadurch gekennzeichnet, daß der Rahmen (50) aus einer Eisen-Nickel-Legierung besteht.

**Claims**

1. A device for hermetically sealing electronic components, the components being encapsulated each in a non-hermetic box (3), said boxes being mounted on a subatrate (1) which carries a printed circuit adapted to ensure the interconnection of the boxes in an electronic circuit, the device being characterized in that the substrate (1) comprises means (4) for external connection which are connected to the electronic circuit, and a cover (2, 20) sealed onto the substrate such as to form a second enclosure (6) which encapsulates in one operation the entire substrate except the connection means, the hermetic sealing of the electronic circuit being ensured by the choice of each of the materials which form the substrate, the cover and the sealing of the cover on the substrate and constituting the second enclosure (6).

2. A device according to claim 1, characterized in that the substrate (1) is made of ceramic material.

3. A device according to claim 1, characterized in that the substrate (1) is covered on its outer faces by a layer of a material which ensures hermetic sealing.

4. A device according to any one of the preceding claims, characterized in that the cover (2) is made of metal or of a ceramic material.

5. A device according to any one of the preceding claims, characterized in that the sealing of the cover on the substrate is made by soldering.

6. A device according to any one of the preceding claims, characterized in that the cover is sealed onto the substrate via a frame (50).

7. A device according to claim 5, characterized in that the frame (50) is constituted by a ferro-nickel-alloy.

## FIG_1-a

## FIG_1-b

## FIG_2